Europäisches Patentamt

European Patent Office

Office européen des brevets

(11) Veröffentlichungsnummer: **0 184 608 B1**

# EUROPÄISCHE PATENTSCHRIFT

(45) Veröffentlichungstag der Patentschrift: **23.12.92**

(51) Int. Cl.5: **H01R 43/16**, H05K 7/10

(21) Anmeldenummer: **85109107.4**

(22) Anmeldetag: **20.07.85**

(54) **Verfahren zur Herstellung mechanisch trennbarer Vielfach-Verbindungen für den elektrischen Anschluss mikroelektronischer Bauelemente und nach diesem Verfahren hergestellte Vielfach-Verbindungen.**

(30) Priorität: **02.11.84 DE 3440110**

(43) Veröffentlichungstag der Anmeldung:
**18.06.86 Patentblatt 86/25**

(45) Bekanntmachung des Hinweises auf die
Patenterteilung:
**23.12.92 Patentblatt 92/52**

(84) Benannte Vertragsstaaten:
**AT CH FR GB IT LI NL SE**

(56) Entgegenhaltungen:
**US-A- 3 953 924**
**US-A- 3 956 052**

**ELECTRONICS, Band 57, Nr. 13, 28. Juni 1984, Seiten 54,56, New York, US; J. LYMAN: "Frame permits use of glass boards"**

**IBM TECHNICAL DISCLOSURE BULLETIN, Band 18, Nr. 5, Oktober 1975, Seiten 1379,1380, New York, US; P. GELDERMANS: "Flexible solder connection and method of fabricating"**

(73) Patentinhaber: **KERNFORSCHUNGSZENTRUM KARLSRUHE GMBH**
**Weberstrasse 5 Postfach 3640**
**W-7500 Karlsruhe 1(DE)**

(72) Erfinder: **Ehrfeld, Wolfgang, Dr.**
**Reutstrasse 27**
**W-7500 Karlsruhe 41(DE)**
Erfinder: **Hagmann, Peter, Dr.**
**Nagoldstrasse 9c**
**W-7514 Eggenstein-Leopoldshafen(DE)**
Erfinder: **Münchmeyer, Dietrich, Dr.**
**Hagäckerstrasse 5**
**W-7513 Stutensee-Spöck(DE)**
Erfinder: **Becker, Erwin Willy, Prof. Dr.**
**Strählerweg 18**
**W-7500 Karlsruhe 41(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Verfahren zur Herstellung einer Vielfach-Verbindung für den elektrischen Anschluß mikroelektronischer Bauelemente gem. dem Oberbegriff von Patentanspruch 1.

Aus der US-PS 4,067,104 ist es bekannt, auf vorgegebenen Kontaktstellen eines mikroelektronischen Bauelements säulenförmige, elastische Verbindungselemente aufzubauen, deren freie Enden mit den Kontaktstellen eines zweiten mikroelektronischen Bauelements verbunden werden. Hierzu wird ein mehrstufiges, lithographisch-galvanisches Verfahren angewandt, bei dem mehrere Photoresistschichten in Folge übereinander angeordnet werden, wobei jede Schicht im Bereich der Kontaktstellen mit Aussparungen versehen wird, die galvanisch mit einem Metall aufgefüllt werden, worauf die nächste Schicht aufgebracht wird. Nach Erreichen einer vorgegebenen Höhe der so entstehenden, metallischen Verbindungselemente werden deren freie Enden mit den entsprechenden Stellen eines weiteren Bauelementes kontaktiert und die Photoresistschichten entfernt.

Dieses stufenweise Vorgehen für den galvanischen Aufbau der Verbindungselemente ist relativ umständlich; auch erfordert das etwaige spätere Auswechseln von Bauelementen einen nicht unbeträchtlichen apparativen und zeitlichen Aufwand.

Der Erfindung liegt die Aufgabe zugrunde, ein Verfahren der gattungsgemäßen Art so zu modifizieren, daß damit auch bei hoher Integrationsdichte mit wirtschaftlich vertretbarem Aufwand mechanisch steck- und trennbare, mikroelektronische Bauelemente bereitgestellt werden können.

Zur Lösung dieser Aufgabe werden die im Kennzeichen der Patentansprüche enthaltenen Maßnahmen vorgeschlagen.

Die Erfindung wird im folgenden anhand der Zeichnungen näher erläutert:

Die Figur 1 zeigt die Montage eines Chips auf einer Substratplatte mit Vielfach-Stecker und Vielfach-Kupplung;

die Figur 2 zeigt einen Schnitt entlang der Linie 2 - 2 von Figur 1;

die Figur 3 zeigt eine Variante der in Figur 1 dargestellten Vielfach-Verbindung;

die Figur 4 zeigt einen Schnitt entland der Linie 4 - 4 von Figur 3.

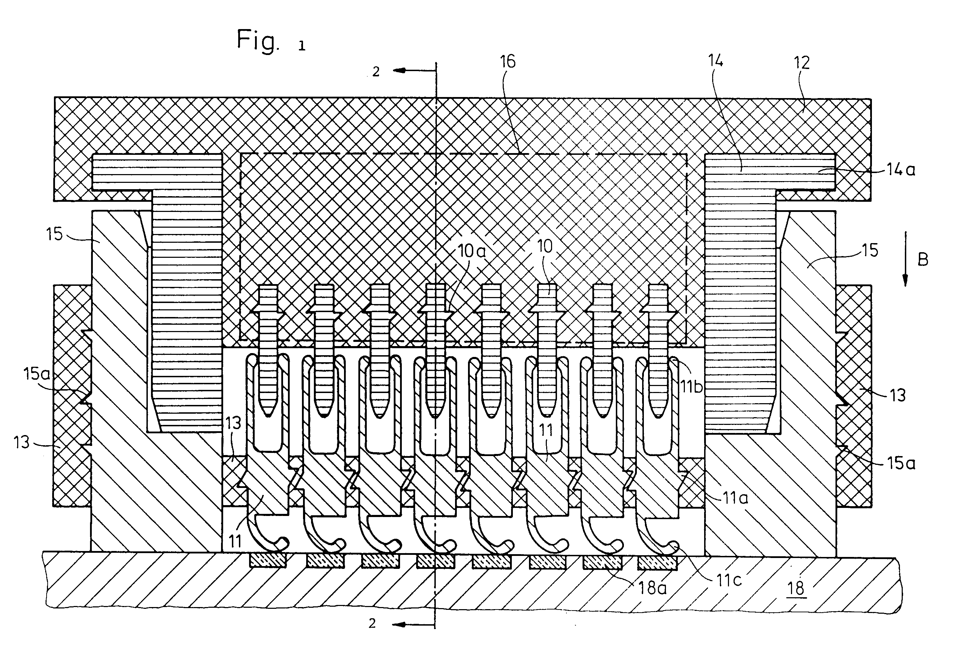

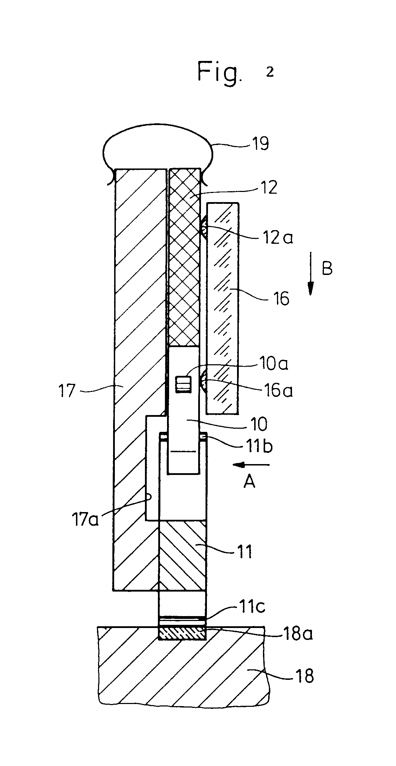

Das in den Figuren 1 und 2 dargestellte Ausführungsbeispiel betrifft eine mechanisch trennbare, aus Vielfach-Stecker und Vielfach-Kupplung bestehende Vielfach-Verbindung für die Montage eines Chips auf einer Substratplatte, wobei die Kontaktstellen des Chips entlang einem Rand des Chips liegen.

Die schneidenförmigen Steckerlemente 10 und die klammerförmigen Kupplungselemente 11 werden durch partielles Bestrahlen mit energiereicher Röntgenstrahlung eines Synchrotrons (Bestrahlungsrichtung siehe Pfeil A in Fig. 2) und Entfernen des bestrahlten Materials je einer PMMA-Resistplatte 12, 13 (Dicke ca. 0,5 mm) und anschließendes galvanisches Auffüllen der so erzeugten Strukturen mit einem Metall hergestellt. Hierbei werden gleichzeitg auch metallische Führungsteile 14 und 15 erzeugt, die das Zusammenfügen der Vielfach-Verbindung erleichtern (Fügerichtung siehe Pfeil B). Die Steckerlemente 10 , die klammerförmigen Kupplungselemente 11 und die Führungsteile 14 und 15 sind zur Verankerung in den Resistplatten 12, 13 mit Verzahnungen 10a, 11a, 14a und 15a versehen. Durch erneutes partielles Bestrahlen und Entfernen von Material der Resistplatten werden die für die mechanisch trennbare Verbindung und die Führung vorgesehenen Bereiche der Elemente 10, 11, 14 und 15 freigelegt, so daß eine Steckerplatte 12 und eine Kupplungsplatte 13 verbleiben. In diesen Platten 12 und 13 sind sowohl die Elemente 10, 11 in vorgesehenem Rasterabstand als auch die Führungsteile 14, 15 fixiert und elektrisch voneinander isoliert.

Will man an Stelle von PMMA ein anderes Isoliermaterial, z.B. das temperaturbeständigere Polyimid, für die Stecker- und Kupplungsplatten verwenden, so werden nach dem Galvanisieren zunächst die für die Stecker- und Kupplungsplatten vorgesehenen Bereiche der PMMA-Resistplatten bestrahlt, herausgelöst und durch das andere Isoliermaterial ersetzt. Anschließend wird das restliche PMMA-Material der Resistplatten durch Auflösen entfernt.

Der Chip 16 wird mit seinen am Rand gelegenen Kontaktstellen 16a mit den in der Steckerplatte 12 fixierten, schneidenförmigen Steckerelementen 10 verlötet. Zusätzlich wird die Steckerplatte 12 mit dem Chip 16 verklebt (Klebestelle 12a). Die Kupplungsplatte 13 trägt auf der dem Chip 16 abgewandten Seite eine Anschlagplatte 17 aus einem elektrisch isolierenden Material, die im Kontaktierungsbereich eine Aussparung 17a aufweist.

Die Kupplungselemente 11 sind mittels federnden Anschlußfahnen 11c mit den Leiterbahnen 18a der Substratplatte 18 verlötet. Die Führungsteile 15 dienen hierbei gleichzeitig als Anschläge auf der Substratplatte 18 und werden mit dieser durch Kleben verbunden. Die federnden Anschlußfahnen 11c gleichen etwaige Unebenheiten der Leiterbahnen 18a der Substratplatte 18 aus.

Der Vielfach-Stecker 10, 12, 14 wird entlang der Anschlagplatte 17 von oben (Pfeil B) in die Vielfach-Kupplung 11, 13, 15 eingeführt, wobei die Enden 11b der klammerförmigen Kupplungselemente 11 den erforderlichen Kontaktdruck sicherstellen. Die Steckerplatte 12 wird zusätzlich durch einen aufsteckbaren Bügel 19 an der Anschlagplatte 17 gehalten.

Durch die senkrechte Anordnung des Chips 16 zur Substratplatte 18 läßt sich eine besonders hohe Integrationsdichte erreichen.

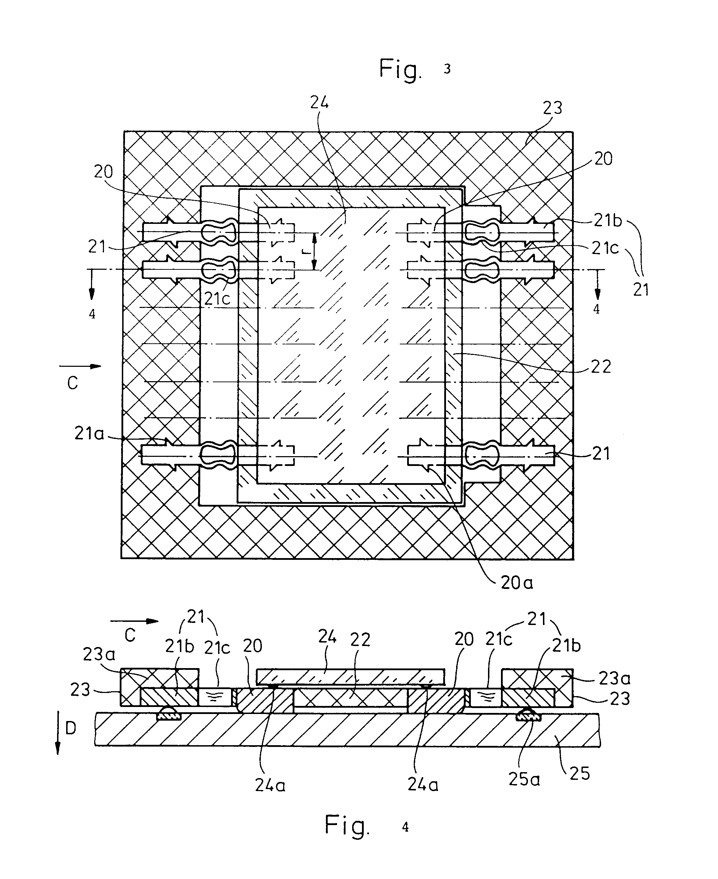

Das in Figur 3 und 4 dargestellte Ausführungsbeispiel betrifft eine mechanisch trennbare Vielfach-Verbindung für die Montage eines Chips auf einer Substratplatte, wobei die Kontaktstellen des Chips entlang einander gegenüberliegender Ränder des Chips angeordnet sind.

Die starren Verbindungselemente 20 mit quaderförmiger Grundform und die federnden Verbindungselemente 21 werden durch partielles Bestrahlen und Entfernen von Material je einer Resistplatte 22,23 und anschließendes galvanisches Auffüllen der so erzeugten Strukturen mit einem Metall 20,21 hergestellt. Sodann werden die für die Fixierung der Elemente 20 und 21 vorgesehenen Bereiche der Resistplatten bestrahlt, herausgelöst und das herausgelöste Resistmaterial durch einen anderen elektrisch isolierenden Stoff wie Epoxidharz ersetzt. Sodann wird das restliche Resistmaterial entfernt, so daß die für die Kontaktgebung vorgesehenen Bereiche der Verbindungselemente 20, 21 freigelegt werden. Auf diese Weise entstehen eine Chip-Trägerplatte 22 und ein diese umschliessender Rahmen 23 aus Epoxidharz, in die die Verbindungselemente 20, 21 in vorgegebenem Rasterabstand eingebettet sind. Dabei kann das Epoxidharz des Rahmens 23, wie aus Figur 4 ersichtlich, die Elemente 21 einseitig überdecken (Überdeckung 23a). Die Elemente 20, 21 sind mit Verzahnungen 20a, 21a versehen. Der Chip 24 wird mit seinen einander gegenüberliegenden Reihen von Kontaktstellen 24a mit den starren Verbindungselementen 20 der Chip-Trägerplatte 22 verlötet.

Die federnden Verbindungselemente 21 im Rahmen 23 werden mit den Leiterbahnen 25a der Substratplatte 25 verlötet. Die federnden Verbindungselemepte 21 haben einen Bereich 21b, der im Epoxidharz des Rahmens 23 eingebettet ist, an den sich der zur Kontaktierung dienende Bereich 21c anschließt. Der Bereich 21c hat die Gestalt einer offenen Acht, wodurch eine Federwirkung in Richtung des Pfeiles C erzielt wird.

Der Chip 24 wird zusammen mit der Chip-Trägerplatte 22 von oben in den Rahmen 23 geschoben, womit die Federrichtung (Pfeil C) senkrecht zur Fügerichtung (Pfeil D) verläuft. Dabei drücken die Elemente 21 mit ihren freien federnden Enden 21c gegen die Kontaktierungsflächen der starren Verbindungselemente 20.

Zum Schutze des Chips beim Ein- und Ausbau kann die Chip-Trägerplatte mit einem den Chip umgebenden, als Handhabe dienenden Rahmen versehen werden; dieser kann zusätzlich mit einem den Chip einbettenden Kunststoff aufgefüllt werden.

Bei einer Realisierung des Verfahrens nach Anspruch 2 werden die galvanisch hergestellten Verbindungselemente auf einer gemeinsamen Halteplatte fixiert, die durch Galvanisieren über die Höhe der Resistplatte hinaus gebildet wird. Nach dem Entfernen des Resistmaterials erhält man ein aus Verbindungselementen und Halteplatte bestehendes Mutterwerkzeug, das wiederholt mit einem Gießharz auf Methacrylatbasis abgeformt wird. Die so erzeugten Strukturen in dem erstarrten plattenartigen Abformmaterial werden sodann in der vorbeschriebenen Weise galvanisch aufgefüllt, worauf diejenigen Teile dieser sekundären Formen, die in den für die Kontaktgebung vorgesehenen Bereichen der Verbindungselemente liegen, durch erneutes partielles Bestrahlen und Auflösen von Abformmaterial entfernt werden.

Selbstverständlich ist es auch in diesen Fällen möglich, das zur gegenseitigen Fixierung der Verbindungselemente verbleibende Abformmaterial (Steckerplatte bzw. Kupplungsplatte) in der oben beschriebenen Weise durch ein anderes Isoliermaterial, z.B. Polyimid, zu ersetzen.

Die hier beschriebenen, mechanisch trennbaren Vielfachverbindungen lassen sich vorteilhaft nicht nur für den Anschluß von Chips, sondern gleichermaßen für den Anschluß anderer mikroelektronischer Bauelemente, wie z.B. Sensor-Arrays oder Flüssigkristallanzeigen, einsetzen.

## Patentansprüche

1. Verfahren zur Herstellung einer Vielfach-Verbindung für den elektrischen Anschluß mikroelektronischer Bauelemente (16, 18), bei dem aus einem strahlenempfindlichen Material (12, 13) durch partielles Bestrahlen und partielles Entfernen dieses Materials Formen hergestellt werden, die an vorgegebenen Positionen Strukturen von Verbindungselementen (10, 11) enthalten, deren Höhe ein Vielfaches ihrer kleinsten, lateralen Abmessungen beträgt und die galvanisch mit einem Metall aufgefüllt werden, wodurch metallische Verbindungselemente (10, 11) entstehen, gekennzeichnet durch folgende Schritte:
   a) durch partielles Bestrahlen und Entfernen von Material je einer Resistplatte (12, 13) aus Polymethylmetacrylat (PMMA) mit energiereicher Röntgenstrahlung eines Synchrotrons und anschließendes galvanisches Auffüllen der so erzeugten Strukturen mit einem Metall werden Verbindungselemente (10, 11) hergestellt;
   b1) sodann werden die für die mechanisch trennbare Verbindung bzw. für die Kontaktgebung vorgesehenen Bereiche der Verbindungselemente (10, 11) durch erneutes partielles Bestrahlen und Entfernen von Material der Resistplatten (12, 13) freigelegt, oder

b2) es werden die für die Fixierung der Verbindungselemente (10, 11) vorgesehenen Bereiche der Resistplatten (12, 13) bestrahlt, herausgelöst und das herausgelöste Resistmaterial durch einen anderen, elektrisch isolierenden Stoff wie Epoxidharz ersetzt, worauf das restliche Resistmaterial entfernt wird.

2. Verfahren nach Anspruch 1, dadurch gekennzeichnet, daß

c) die galvanisch hergestellten Verbindungselemente auf einer gemeinsamen Halteplatte fixiert werden, die durch Galvanisieren über die Höhe der Resistplatten hinaus gebildet wird,

d) das Resistmaterial entfernt und das so erhaltene Mutterwerkzeug wiederholt mit einem Gießharz auf Methacrylatbasis als Abformmaterial abgeformt wird, worauf

e) die so erzeugten Strukturen in dem Abformmaterial galvanisch aufgefüllt und

f) diejenigen Teile des Abformmaterials, die in den für die Kontaktgebung vorgesehenen Bereichen liegen, durch erneutes Bestrahlen und Auflösen von Abformmaterial entfernt werden.

**Claims**

1. Method of producing a multiconnector for the electrical connection of micro-electronic components (16, 18), wherein moulds are produced from a radiation-sensitive material (12, 13) by a partial irradiation and a partial removal of this material, which moulds contain, at prescribed positions, structures of connection elements (10, 11), the height of which amounts to a multiple of their minimum lateral dimensions, and which structures are galvanically filled with a metal, metallic connection elements (10, 11) resulting therefrom, characterised by the following steps:

a) connection elements (10, 11) are produced by a partial irradiation and removal of material of each resist plate (12, 13), formed from polymethyl methacrylate (PMMA), with the utilisation of energy-rich X-radiation of a synchrotron and by a subsequent galvanic filling of the structures, thus produced, with a metal;

b1) the regions of the connection elements (10, 11), which are provided for the mechanically separable connection or for the contact-making, are then exposed by a fresh, partial irradiation and removal of material of the resist plates (12, 13); or

b2) the regions of the resist plates (12, 13), which are provided for the securement of the connection elements (10, 11), are irradiated and eliminated, and the eliminated resist material is replaced by a different, electrically insulating substance such as epoxy resin, whereupon the remaining resist material is removed.

2. Method according to claim 1, characterised in that

c) the galvanically produced connection elements are secured on a common retaining plate, which is formed beyond the height of the resist plates by galvanisation;

d) the resist material is removed, and the mother tool, thus obtained, is repeatedly shaped with the utilisation of a casting resin based on methacrylate as the shaping material; whereupon

e) the structures thus produced in the shaping material are galvanically filled; and

f) those portions of the shaping material, which are situated in the regions provided for the contact-making, are removed by a fresh irradiation and an elimination of shaping material.

**Revendications**

1. Procédé de fabrication d'une connexion multiple pour le branchement électrique de composants micro-électroniques (16, 18), selon lequel on fabrique dans un matériau (12, 13) sensible à l'irradiation, par irradiation partielle et enlèvement partiel de cette matière, des formes qui comportent dans des positions prédéterminées, les structures des éléments de liaison (10, 11), dont la hauteur correspond à un multiple de leurs plus petites dimensions latérales, et que l'on remplit galvaniquement avec un métal pour former des éléments de connexion métalliques (10, 11), procédé caractérisé en ce que,

a) on irradie partiellement et on enlève de la matière de chaque plaque photorésistante (12, 13) en polyméthyl-métacrylate PMMA avec une irradiation aux rayons X fortement énergétique d'un synchrotron, puis on remplit galvaniquement les structures ainsi formées avec du métal pour fabriquer des éléments de connexion (10, 11),

b1) puis on dégage les connexions séparables mécaniquement ou les zones prévues pour le contact des éléments de connexion (10, 11) par une nouvelle irradiation et enlèvement de la matière des plaques photorésistantes (12, 13), ou,

b2) les zones des plaques photorésistantes
(12, 13) prévues pour la fixation des éléments de connexion sont irradiées, éliminées et la matière photorésistante ainsi enlevée est remplacée par une autre matière
isolante électrique comme une résine époxy
puis on enlève la matière photorésistante
résiduelle.

2. Procédé selon la revendication 1, caractérisé
en ce que

c) on fixe les éléments de connexion fabriqués galvaniquement sur une plaque de
fixation commune, qui est constituée au-
delà de la hauteur des plaques photorésistantes par opération galvanique,

d) on enlève la matière photorésistante et
on utilise de manière répétée la matrice
ainsi obtenue pour servir de moule pour de
la résine de coulée à base de polyméthyl-
métacrylate, comme matière de moulage,
puis,

e) on remplit galvaniquement les structures
ainsi formées dans la matière de moulage
et,

f) pour les parties de la matière de moulage
qui se situent dans les zones prévues pour
les contacts, on irradie de nouveau et on
dissout la matière de moulage.

Fig. 1

EP 0 184 608 B1

Fig. 2

Fig. 3

Fig. 4